# EUROPÄISCHE PATENTSCHRIFT

(11) **EP 2 098 674 B1**
(45) Veröffentlichungstag und Bekanntmachung des Hinweises auf die Patenterteilung: **25.08.2010**
(21) Anmeldenummer: 09002004.1
(22) Anmeldetag: 13.02.2009
(51) Int. Cl.: E06B 3/66, F21V 33/00

(54) **Licht erzeugendes Wandelement**
Light-emitting wall element
Elément mural produisant de la lumière

(30) Priorität: 04.03.2008 DE 102008012383
(43) Veröffentlichungstag der Anmeldung: 09.09.2009
(73) Patentinhaber: Fraunhofer-Gesellschaft zur Förderung der angewandten Forschung e.V., 80686 München (DE)
(72) Erfinder: Kirchhoff, Volker, 01829 Wehlen (DE); Kopte, Torsten, 01731 Kreischa (DE); Kubusch, Jörg, 01279 Dresden (DE)

(56) Entgegenhaltungen:
- WO-A-2004/034483
- WO-A-2008/026170
- DE-A1-102006 037 929
- DE-A1-102006 060 781
- DE-U1- 29 510 238

## Beschreibung

Die Erfindung betrifft ein Wandelement, welches beispielsweise als Fenster, Tür oder Raumteiler ausgebildet ist und gleichzeitig eine Licht erzeugende Funktion ausüben kann.

Aus Schall- oder Wärmeschutzgründen ist es beispielsweise bekannt, als Fenster oder Glastüren ausgebildete Wandelemente mit Doppelglasscheiben auszustatten. Dabei begrenzen die gegenüberliegend angeordneten Glasscheiben einen Hohlraum, der mit einem Gas geringer Wärmeleitfähigkeit gefüllt sein kann, um die Wärmeverluste weiter zu reduzieren. In DE 24 43 390 A1 wird außerdem empfohlen, zur Verbesserung der Wärmeisolation zumindest eine der Glasscheiben auf der dem Hohlraum zugewandten Seite mit einer Metall-schicht zu versehen.

DE 10 2006 009 620 A1 beschreibt ein zwei Glasscheiben umfassendes Fenster- oder Fassadenelement, welches gleichzeitig zu Dekorationszwecken verwendet werden kann. Dazu wird der Raum zwischen den Glasscheiben mit einem ionisierten und mit Quecksilber angereicherten Gas befüllt, welches bei Anlegen einer Spannung aufleuchtet. Das Fensterelement umfasst ferner Mittel zum Zünden und Aufrechterhalten einer Entladung. Nach dem Wirkprinzip einer Neon-Leuchte kann mit solch einem Doppelfenster auch Licht erzeugt und zu Dekorationszwecken verwendet werden. Ein Nachteil eines solchen Fensters ergibt sich jedoch dann, wenn das quecksilberhaltige Gas aus dem Zwischenraum entweicht und durch Menschen eingeatmet wird.

### Aufgabenstellung

Der Erfindung liegt daher das technische Problem zugrunde ein Wandelement zu schaffen, welches einerseits als Fenster oder Tür verwendet werden und andererseits eine Licht erzeugende Funktion ausüben kann. Dabei soll das Wandelement keine quecksilberhaltigen Gase oder andere Gase umfassen, welche beim Menschen eine gesundheitsschädigende Wirkung herbeiführen können.

Die Lösung des technischen Problems ergibt sich durch die Gegenstände mit den Merkmalen des Patentanspruchs 1. Weitere vorteilhafte Ausgestaltungen der Erfindung ergeben sich aus den abhängigen Patentansprüchen.

Ein erfindungsgemäßes Licht erzeugendes Wandelement, umfasst ein erstes transparentes Substrat und ein zweites transparentes Substrat, wobei beide scheibenförmig ausgebildeten transparenten Substrate gegenüberliegend angeordnet sind und einen Hohlraum begrenzen. Dabei ist auf einem der zwei transparenten Substrate zumindest in einem Oberflächenbereich zumindest ein erstes Schichtsystem abgeschieden, welches eine erste elektrisch leitfähige Schicht, gefolgt von einer Licht emittierenden Schicht und einer zweiten elektrisch leitfähigen Schicht umfasst. Des Weiteren ist zwischen der ersten elektrisch leitfähigen Schicht und der zweiten elektrisch leitfähigen Schicht eine erste elektrische Spannung schaltbar, wobei das Anlegen der ersten elektrischen Spannung zwischen der ersten und zweiten elektrisch leitfähigen Schicht das Emittieren von Licht aus der Licht emittierenden Schicht heraus bewirkt.

Das erste Schichtsystem als transparentes Schichtsystem auszubilden ist insbesondere dann zweckmäßig, wenn das Wandelement als Fenster oder als Glastür fungiert. Bei einer Ausführungsform weist das Wandelement im sichtbaren Wellenlängenbereich eine Transparenz von mindestens 35 % auf. Ein erfindungsgemäßes Wandelement kann hingegen auch als Überkopfverglasung, fest montierter oder auch ortsveränderlicher Raumteiler ausgebildet sein, wobei dann bezüglich der Transparenz oftmals nicht so hohe Werte wie bei einem Fenster erfüllt werden müssen bzw. wobei eine geringere Transparenz manchmal auch wünschenswert ist. Das erste Schichtsystem kann sowohl auf dem ersten transparenten Substrat als auch auf dem zweiten transparenten Substrat und sowohl auf der Außenseite des Substrates als auch auf der dem Hohlraum zugewandten Seite des Substrates abgeschieden sein. Vorteilhaft ist es jedoch, wenn das erste Schichtsystem auf dem Substrat abgeschieden ist, welches dem Inneren eines Gebäuderaumes zugewandt ist. Des Weiteren ist es zweckmäßig, das erste Schichtsystem auf der dem Hohlraum zugewandten Seite des Substrates abzuscheiden, weil das Schichtsystem auf diese Weise vor mechanischer Beanspruchung wie beispielsweise Kratzen geschützt ist. Weiterhin kann das Schichtsystem dann auch vor oxidativen Einflüssen geschützt werden, wenn der Hohlraum mit einem Gas wie beispielsweise Argon, Krypton oder Xenon gefüllt ist. Bei den Ausführungsbeispielen, bei denen sich ein Gas im Hohlraum befindet, weist ein erfindungsgemäßes Wandelement einen an den transparenten Substraten umlaufenden gasdichten Abstandshalter auf, der den Hohlraum zwischen den transparenten Substraten abdichtet.

Bei einem erfindungsgemäßen Wandelement bestehen das erste transparente Substrat oder/und das zweite transparente Substrat vorzugsweise aus Glas. Alternativ können das erste transparente Substrat oder/und das zweite transparente Substrat auch aus einem Kunststoff bestehen.

Auch bei der Ausgestaltung der beiden elektrisch leitfähigen Schichten stehen Alternativen zur Verfügung. Bei einer Ausgestaltungsform sind die erste elektrisch leitfähige Schicht oder/und die zweite elektrisch leitfähige Schicht als Einzelschicht ausgebildet. Das Schichtmaterial kann zum Beispiel ein transparentes leitfähiges Oxid (Transparent Conductive Oxid - nachfolgend vereinfacht als TCO bezeichnet) wie beispielsweise Indium-Zinn-Oxid oder aluminiumdotiertes Zinkoxid umfassen. Sind die erste elektrisch leitfähige Schicht oder/und die zweite elektrisch leitfähige Schicht als Einzelschicht ausgebildet, so sind Schichtdicken von 50 nm bis 500 nm geeignet.

Alternativ können die erste elektrisch leitfähige Schicht oder/und die zweite elektrisch leitfähige Schicht auch aus einem Schichtverbund bestehen. Solch ein Schichtverbund kann beispielsweise eine erste TCO-Schicht und eine zweite TCO-Schicht umfassen, zwischen die eine Silber-Schicht eingebettet ist. Als TCO-Materialien können beispielsweise wieder die Materialien Indium-Zinn-Oxid oder aluminiumdotiertes Zinkoxid verwendet werden. Als Schichtdickenbereiche sind für die erste und die zweite TCO-Schicht 20 nm bis 50 nm und für die Silber-Schicht 5 nm bis 15 nm geeignet.

Ein wesentlicher Bestandteil eines erfindungsgemäßen Wandelements ist die Licht emittierende Schicht. Als Materialien für die Licht emittierende Schicht sind solche Materialien geeignet, die auch von Leuchtdioden her bekannt sind. Dies sind insbesondere anorganische Halbleitermaterialien wie beispielsweise Galliumaluminiumarsenid, Galliumarsenidphosphid, Aluminiumindiumgalliumphosphid, Galliumphosphid, Indiumgalliumnitrid oder Galliumnitrid oder auch organische Halbleitermaterialien wie beispielsweise Chinacridon, Flavanthron oder Perinon. Besonders geeignet für ein erfindungsgemäßes Wandelement sind die organischen Halbleitermaterialen, weil diese Materialien gegenüber anorganischen Halbleitermaterialien bei gleicher Schichtdicke eine höhere Transparenz aufweisen. Für die Licht emittierende Schicht kann eine Schichtdicke im Bereich von 10 nm bis 1000 nm ausgewählt werden.

Eine Ausführungsform umfasst ein zweites Schichtsystem mit Wärme dämmenden Eigenschaften. Derartige Schichtsysteme werden auch als low-e-Schichtsysteme bezeichnet. Das low-e-Schichtsystem kann wahlweise auf dem ersten oder/und zweiten transparenten Substrat abgeschieden sein. Ein low-e-Schichtsystem kann beispielsweise folgenden Schichtaufbau umfassen: Metalloxid-Schicht, Silber-Schicht, Metall-Schicht, Metalloxid-Schicht. Alternativ kann ein low-e-Schichtsystem aber auch weitere Schichten umfassen, welche als Haft-, Blocker-, Deck- oder Schutzschichten ausgebildet sein können. Als Material für die Metall-Schicht ist beispielsweise eine Nickel-Chrom-Verbindung geeignet. Ein erfindungsgemäßes Wandelement, welches ein low-e-Schichtsystem umfasst, weist senkrecht zur Oberfläche der transparenten Substrate ein Emissionsvermögen von maximal 0,1 auf. Ist das Wandelement mit low-e-Schichtsystem als Fenster oder Glastür ausgebildet, erweist sich eine Transparenz im sichtbaren Wellenlängenbereich von mindestens 25 % als vorteilhaft. Ist das Wandelement als Überkopfverglasung oder als Raumteiler ausgebildet, ist oftmals schon eine Transparenz im sichtbaren Wellenlängenbereich oberhalb von 15 % hinreichend.

Zum Erzielen von Wärme dämmenden Eigenschaften ist aber nicht zwangsweise ein zweites Schichtsystem erforderlich. Das Licht erzeugende erste Schichtsystem, bei welchem die erste und zweite elektrisch leitfähige Schicht auch als Metalloxid-Schicht ausgebildet sein können, kann bei der Materialwahl der einzelnen Schichten und/oder bei der Wahl der Schichtdicken derart aufeinander abgestimmt sein, dass das erste Schichtsystem auch low-e-Eigenschaften aufweist. Des Weiteren kann das erste Schichtsystem auch durch weitere Schichten ergänzt sein, um low-e-Eigenschaften zu erzielen. So können beispielsweise auf der zweiten elektrisch leitfähigen Schicht zusätzlich noch eine Silber-Schicht und eine Metalloxid-Schicht abgeschieden sein, um die erwünschten low-e-Eigenschaften zu erzielen.

Dass mittels des ersten Schichtsystems durch das Anlegen einer Spannung zwischen der ersten und zweiten elektrisch leitfähigen Schicht Licht erzeugt werden kann, wurde bereits oben beschrieben. Mit einem Schichtsystem wie dem ersten Schichtsystem kann jedoch auch eine umgekehrte Wirkung erzielt werden. Wird die Licht erzeugende Schicht mit Licht wie beispielsweise Sonnenlicht beaufschlagt, entsteht zwischen der ersten und zweiten elektrisch leitfähigen Schicht eine elektrische Spannung. Bei einer Ausführungsform weisen daher die erste und zweite elektrisch leitfähige Schicht Kontaktmittel auf, an denen eine elektrische Spannung abgreifbar ist. Ist ein derartiges Wandelement beispielsweise in der Außenwand eines Gebäudes integriert, kann auf diese Weise bei Sonneneinstrahlung ein elektrischer Strom gewonnen werden.

Alternativ kann jedoch auch ein drittes Schichtsystem, mit den gleichen Schichtaufbauvarianten wie beim ersten Schichtsystem, auf einem der beiden transparenten Substrate abgeschieden sein, so dass mit dem ersten Schichtsystem nur die Licht erzeugende Funktion und mit dem dritten Schichtsystem nur die Strom erzeugende Funktion ausgeübt wird. Das dritte Schichtsystem kann beispielsweise folgenden Schichtaufbau beginnend am Substrat aufweisen: dritte elektrisch leitfähige Schicht, Schicht aus Chinacridon, vierte elektrisch leitfähige Schicht. Die dritte elektrisch leitfähige Schicht kann zum Beispiel als TCO-Schicht und die vierte elektrisch leitfähige Schicht als Schichtfolge, umfassend eine TCO-Schicht, eine Silberschicht und wieder eine TCO-Schicht, ausgebildet sein.

Bei einer weiteren Ausführungsform umfasst ein erfindungsgemäßes Wandelement ein viertes Schichtsystem, mittels dem das Wandelement, welches beispielsweise als Fenster ausgebildet und in einer Gebäudeaußenwand integriert sein kann, nach außen hin abgedunkelt und/oder mittels dem das von der Licht emittierenden Schicht nach außen hin emittierte Licht in den Raum zurück reflektiert werden kann. Für derartige Funktionen sind im Stand der Technik Schichtsysteme unter den Bezeichnungen elektrochromes Schichtsystem, gasochromes Schichtsystem oder schaltbarer Spiegel bekannt. Das vierte Schichtsystem ist vorzugsweise auf dem nach außen gerichteten transparenten Substrat abzuscheiden.

Das vierte Schichtsystem kann beispielsweise eine Wolframoxid-Schicht umfassen, die auf der dem Hohlraum zugewandten Seite eines der beiden transparenten Substrate abgeschieden ist. Das Schalten der Verdunkelungsfunktion erfolgt, indem Wasserstoff in den Hohlraum zwischen den beiden transparenten Substraten eingelassen wird. Aufgehellt werden kann die Schicht wiederum, indem der Wasserstoff abgepumpt und Sauerstoff in den Hohlraum eingelassen wird.

Neben Wolframoxid sind auch Schichten auf Metallhybridbasis geeignet, unter der Einwirkung von Wasserstoff die Transparenz zu verändern bzw. als Spiegel zu wirken. Ein alternatives viertes Schichtsystem kann beispielsweise eine Ytrium-Schicht und eine Paladium-Schicht umfassen, die ebenfalls auf der dem Hohlraum zugewandten Seite eines der transparenten Substrate abgeschieden sind. Derartige Schichtsysteme, bei denen das Schalten der Transparenz durch das Zuführen von Wasserstoff erfolgt, werden auch als Hydrogen Switchable Mirrors (HYSWIM) bezeichnet.

Das Schalten der Transparenz eines vierten Schichtsystems kann jedoch auch alternativ durch das Anlegen einer elektrischen Spannung bewirkt werden. Bei einer solchen Ausführungsform wird eines der beiden transparenten Substrate im Verbund mit einem dritten transparenten Substrat ausgeführt, wobei zwischen diesen beiden transparenten Substraten das vierte Schichtsystem abgeschieden wird. Ein solches alternatives viertes Schichtsystem kann beispielsweise folgende Schichtfolge umfassen: fünfte transparente leitfähige Schicht, Wolframoxid-Schicht, Ionen-leitfähige Schicht, lonen-haltige Schicht, sechste elektrisch leitfähige Schicht. Durch das Anlegen einer vierten elektrischen Spannung zwischen der fünften und sechsten elektrisch leitfähigen Schicht kann die Transparenz des vierten Schichtsystems verändert werden.

Als Ionen-leitfähige Schicht kann beispielsweise ein Ionen-leitfähiges Polymer verwendet werden und als Ionen-haltige Schicht ist beispielsweise eine Schicht geeignet, welche Lithium enthält.

Es sei erwähnt, dass die Beschreibung der vier Schichtsysteme mit deren Schichtreihenfolge nur Beispielcharakter aufweist. Bei der Beschreibung wurden nur solche Schichten beschrieben, welche zum Ausüben der jeweiligen Funktion eines Schichtsystems erforderlich sind. Jedes der zuvor beschriebenen Schichtsysteme eins bis vier kann jedoch durch weitere Schichten ergänzt werden, welche eine Funktion als Haft-, Blocker-, Barriere-, Deck- und/ oder Schutzschicht ausüben.

Die Schichtsysteme eins bis vier können wahlweise direkt auf den transparenten Substraten abgeschieden sein. Es besteht jedoch auch die Möglichkeit, eines der Schichtsysteme eins bis vier zunächst auf einem flexiblen Trägersubstrat wie einer Kunststofffolie abzuscheiden und die Kunststofffolie anschließend auf eines der transparenten Substrate zu laminieren.

Eine weitere Ausgestaltungsform eines erfindungsgemäßen Wandelements zeichnet sich durch ein Trockenmittel aus, das in den Halter eingearbeitet ist, welcher die beiden transparenten Substrate voneinander beabstandet. Ein solches Trockenmittel kann beispielsweise als Siliziumoxid ausgebildet sein und dient dazu, dem Hohlraum zwischen den transparenten Substraten die Feuchtigkeit zu entziehen.

Weiterhin kann auch ein Gettermaterial in den Abstandshalter integriert sein, welches Restsauerstoff aus dem Hohlraum bindet, wodurch die auf der dem Hohlraum zugewandten Seite der transparenten Substrate abgeschiedenen Schichten vor Oxidation geschützt werden.

### Ausführungsbeispiel

Die Erfindung wird nachfolgend anhand bevorzugter Ausführungsbeispiele näher erläutert. Die Fig. zeigen:
Fig. 1 einen Ausschnitt einer schematischen Querschnittsdarstellung eines erfindungsgemäßen Wandelements;
Fig. 2 einen Ausschnitt einer schematischen Querschnittsdarstellung eines alternativen erfindungsgemäßen Wandelements mit einem Schichtsystem zum Verändern der Transparenz des Wandelements.

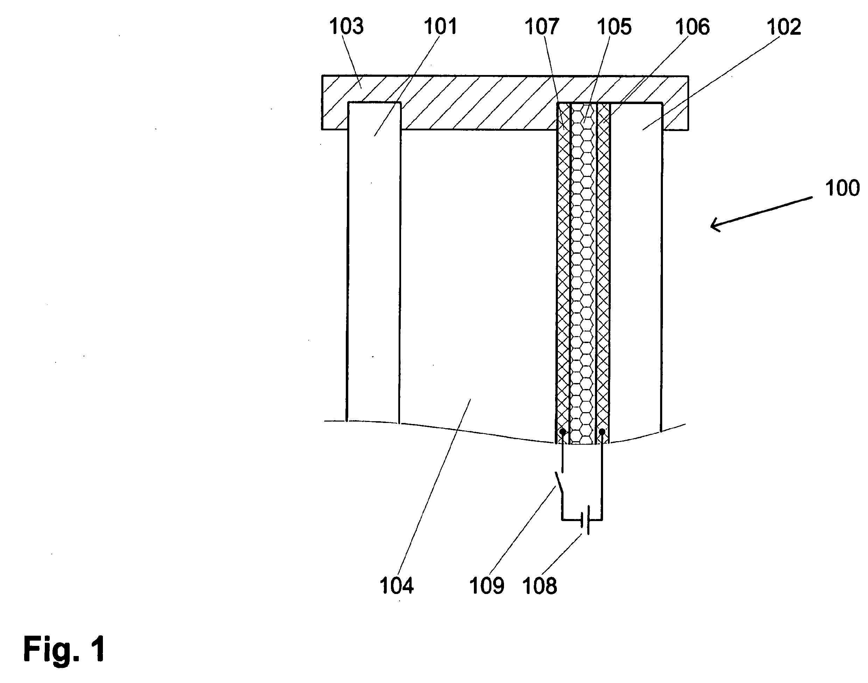

In Fig. 1 ist ein Ausschnitt eines als Fenster ausgebildeten erfindungsgemäßen Wandelements 100 schematisch im Schnitt dargestellt. Das Wandelement 100 umfasst eine erste 4 mm dicke Glasscheibe 101 und eine zweite 4 mm dicke Glasscheibe 102, welche 16 mm voneinander beabstandet sind und mit einem an den Rändern der Glasscheiben 101 und 102 umlaufenden gasdichten Abstandshalter 103 einen Hohlraum 104 begrenzen. Hohlraum 104 ist mit dem Gas Argon gefüllt.

Das Fenster 100 ist derart in eine Gebäudeaußenwand eingebaut, dass sich die Glasscheibe 101 auf der Außenseite befindet und die Glasscheibe 102 einem Raum im Gebäudeinneren zugewandt ist. Auf der dem Hohlraum 104 zugewandte Seite der Glasscheibe 102 ist ein transparentes Schichtsystem abgeschieden, bei welchem eine 500 nm dicke organische Halbleiterschicht 105 aus Chinacridon zwischen zwei jeweils 130 nm dicken TCO-Schichten 106 und 107 aus Indium-Zinn-Oxid eingebettet ist. Mittels einer Spannungsquelle 108 und durch das Betätigen eines Schalters 109 ist zwischen den beiden TCO-Schichten 106 und 107 eine elektrische Spannung zuschaltbar. Beim Zuschalten dieser Spannung wird aus der Halbleiterschicht 105 Licht emittiert, welches sowohl in den Raum als auch in Richtung Gebäudeäußeres strahlt.

Das Wandelement 100 kann daher zwei Funktionen ausüben. Zum einen fungiert es als transparentes Fenster und zum anderen übt es bei geschlossenem Schalter 108 eine Licht erzeugende Funktion aus.

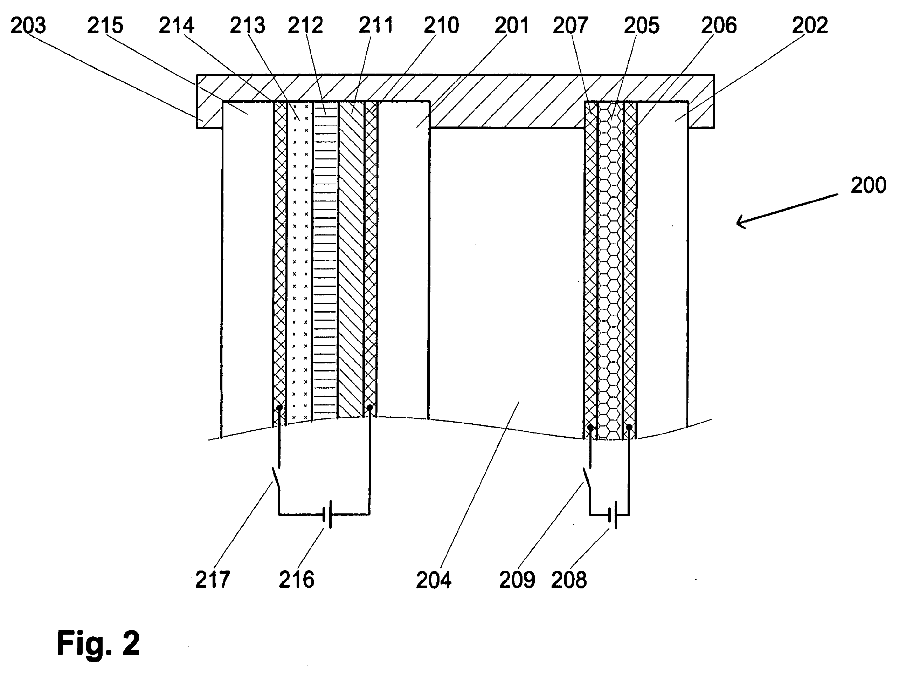

Ein Ausschnitt eines als Fenster ausgebildeten alternativen erfindungsgemäßen Wandelements 200 ist in Fig. 2 schematisch im Schnitt dargestellt. Analog zum Wandelement 100 aus Fig. 1 umfasst das Wandelement 200 eine erste 4 mm dicke Glasscheibe 201 und eine zweite 4 mm dicke Glasscheibe 202, welche voneinander 16 mm beabstandet sind und mit einem an den Rändern der Glasscheiben 201 und 202 umlaufenden gasdichten Abstandshalter 203 einen Hohlraum 204 begrenzen. Hohlraum 204 ist mit dem Gas Argon gefüllt. Die Glasscheibe 202 ist einem Gebäuderaum zugewandt, der mittels des Wandelements 200 ausgeleuchtet werden soll. Auf der dem Hohlraum 204 zugewandten Seite der Glasscheibe 202 ist ein transparentes Schichtsystem abgeschieden, bei welchem eine 400 nm dicke organische Halbleiterschicht 205 aus Chinacridon zwischen zwei jeweils 200 nm dicken TCO-Schichten 206 und 207 aus Indium-Zinn-Oxid eingebettet ist. Mittels einer Spannungsquelle 208 und durch das Betätigen eines Schalters 209 ist zwischen den beiden TCO-Schichten 206 und 207 eine elektrische Spannung zuschaltbar. Beim Zuschalten dieser Spannung wird aus der Halbleiterschicht 205 Licht emittiert, welches sowohl in den auszuleuchtenden Raum als auch in Richtung Gebäudeäußeres strahlt.

Des Weiteren ist die erste Glasscheibe 201 Bestandteil eines Schichtverbundes, der neben der Glasscheibe 201 eine elektrisch leitfähige Schicht 210, eine als Ionen-Speicher fungierende Schicht 211, eine Ionen-leitfähige Polymerfolie 212, eine 300 nm unterstöchiometrische Wolframoxid-Schicht 213, eine weitere elektrisch leitfähige Schicht 214 und zum Abschluss eine weitere 4 mm dicke Glasscheibe 215 umfasst. Die beiden jeweils 150 nm dicken elektrisch leitfähigen Schichten 210 und 214 bestehen aus Indium-Zinn-Oxid und in der als Ionen-Speicher fungierenden Schicht 211 befindet sich Lithium als Schichtmaterial.

Mittels einer Spannungsquelle 216 und über einen Schalter 217 ist eine elektrische Spannung zwischen die beiden elektrisch leitfähigen Schichten 210 und 214 schaltbar. Das Schalten dieser Spannung bewirkt eine Veränderung hinsichtlich der Transparenz der Wolframoxid-Schicht 213, wobei sich die Transparenz in Abhängigkeit von der angelegten Spannung stufenlos regeln lässt. Auf diese Weise kann der mit dem Wandelement 200 auszuleuchtende Raum zum Gebäudeäußeren hin abgedunkelt werden.

## Patentansprüche

1. Licht erzeugendes Wandelement (100; 200), umfassend ein erstes transparentes Substrat (101; 201) und ein zweites transparentes Substrat (102; 202), wobei beide scheibenförmig ausgebildeten transparenten Substrate gegenüberliegend angeordnet sind und einen Hohlraum (104; 204) begrenzen, **dadurch gekennzeichnet, dass** auf dem zweiten Substrat (102; 202) zumindest in einem Oberflächenbereich zumindest ein erstes Schichtsystem, umfassend eine erste elektrisch leitfähige Schicht (106; 206), gefolgt von einer Licht emittierenden Schicht (105; 205) und einer zweiten elektrisch leitfähigen Schicht (107; 207), abgeschieden ist und wobei zwischen der ersten elektrisch leitfähigen Schicht (106; 206) und der zweiten elektrisch leitfähigen Schicht (107; 207) eine erste elektrische Spannung schaltbar ist.

2. Wandelement nach Anspruch 1, **dadurch gekennzeichnet, dass** das Wandelement (100; 200) als Fenster, als Tür oder als Raumteiler ausgebildet ist.

3. Wandelement nach Anspruch 1 oder 2, **dadurch gekennzeichnet, dass** das erste transparente Substrat (101; 201) oder/und das zweite transparente Substrat (102; 202) aus Glas oder aus einem Kunststoff besteht/bestehen und dass das erste Schichtsystem transparent ausgebildet ist.

4. Wandelement nach einem der vorhergehenden Ansprüche, **dadurch gekennzeichnet, dass** die erste elektrisch leitfähige Schicht (106; 206) oder/und die zweite elektrisch leitfähige Schicht (107; 207) als 50 nm bis 500 nm dicke Einzelschicht ausgebildet ist/sind, wobei die Einzelschicht aus einem transparenten leitfähigen Oxid und insbesondere aus Indium-Zinn-Oxid oder aus aluminiumdotiertem Zinkoxid besteht.

5. Wandelement nach einem der vorhergehenden Ansprüche, **dadurch gekennzeichnet, dass** die erste elektrisch leitfähige Schicht oder/und die zweite elektrisch leitfähige Schicht aus einem Schichtverbund besteht/bestehen, wobei der Schichtverbund zumindest eine 20 nm bis 50 nm dicke erste Schicht und eine 20 nm bis 50 nm dicke zweite Schicht jeweils aus einem transparenten leitfähigen Oxid, insbesondere aus Indium-Zinn-Oxid oder aus aluminiumdotiertem Zinkoxid, umfasst, zwischen die eine 5 nm bis 15 nm dicke Silber-Schicht eingebettet ist.

6. Wandelement nach einem der Ansprüche 1 bis 5, **dadurch gekennzeichnet, dass** die Licht emittierende Schicht aus einem anorganischen Halbleitermaterial besteht und eine Schichtdicke von 10 nm bis 1000 nm aufweist.

7. Wandelement nach Anspruch 6, **dadurch gekennzeichnet, dass** die Licht emittierende Schicht aus mindestens einer der Verbindungen Galliumaluminiumarsenid, Galliumarsenidphosphid, Aluminiumindiumgalliumphosphid, Galliumphosphid, Indiumgalliumnitrid oder Galliumnitrid besteht.

8. Wandelement nach einem der Ansprüche 1 bis 5, **dadurch gekennzeichnet, dass** die Licht emittierende Schicht (105; 205) aus einem organischen Halbleitermaterial besteht und eine Schichtdicke von 10 nm bis 1000 nm aufweist.

9. Wandelement nach Anspruch 8, **dadurch gekennzeichnet, dass** die Licht emittierende Schicht (105; 205) aus mindestens einer der Verbindungen Chinacridon, Flavanthron oder Perinon besteht.

10. Wandelement nach einem der vorhergehenden Ansprüche, **dadurch gekennzeichnet, dass** das erste Schichtsystem auf der dem Hohlraum zugewandten Seite oder auf der dem Hohlraum abgewandten Seite des zweiten transparenten Substrates (102; 202) abgeschieden ist.

11. Wandelement nach einem der Ansprüche 1 bis 10, **dadurch gekennzeichnet, dass** das erste Schichtsystem gleichzeitig als low-e-Schichtsystem ausgebildet ist oder dass auf dem ersten transparenten Substrat ein zweites Schichtsystem abgeschieden ist, welches low-e-Eigenschaften aufweist, wobei das zweite Schichtsystem, beginnend am Substrat, mindestens folgende Schichten umfasst: Metalloxid-Schicht, Silber-Schicht, Metall-Schicht, Metalloxid-Schicht.

12. Wandelement nach einem der vorhergehenden Ansprüche, **dadurch gekennzeichnet, dass** das Wandelement senkrecht zur Oberfläche ein Emissionsvermögen von maximal 0,1 aufweist.

13. Wandelement nach einem der Ansprüche 1 bis 10, **dadurch gekennzeichnet, dass** das Wandelement eine Transparenz im sichtbaren Bereich von mindestens 35 % aufweist.

14. Wandelement nach einem der vorhergehenden Ansprüche, **dadurch gekennzeichnet, dass** der Hohlraum (104; 204) mit einem Gas, insbesondere mit Argon, Krypton oder Xenon oder einem Gemisch dieser Gase, gefüllt ist.

15. Wandelement nach einem der Ansprüche 1 bis 14, **dadurch gekennzeichnet, dass** bei Lichteinfall auf das Wandelement zwischen der ersten elektrisch leitfähigen Schicht und der zweiten elektrisch leitfähigen Schicht eine zweite elektrische Spannung abgreifbar ist.

16. Wandelement nach einem der Ansprüche 1 bis 14, **dadurch gekennzeichnet, dass** das erste transparente Substrat ein drittes Schichtsystem umfasst, mittels dem bei Lichteinfall auf das Wandelement eine dritte elektrische Spannung erzeugbar ist.

17. Wandelement nach Anspruch 16, **dadurch gekennzeichnet, dass** das dritte Schichtsystem mindestens folgende Schichten, beginnend am Substrat, umfasst: dritte elektrisch leitfähige Schicht, Schicht aus Chinacridon, vierte elektrisch leitfähige Schicht, wobei zwischen der dritten elektrisch leitfähigen Schicht und der vierten elektrisch leitfähigen Schicht die dritte elektrische Spannung abgreifbar ist.

18. Wandelement nach einem der vorhergehenden Ansprüche, **dadurch gekennzeichnet, dass** das erste transparente Substrat ein viertes Schichtsystem umfasst, welches als schaltbarer Spiegel ausgebildet ist oder/und mittels dem die Transparenz des Wandelements veränderbar ist.

19. Wandelement nach Anspruch 18, **dadurch gekennzeichnet, dass** das erste transparente Substrat (201) Bestandteil eines Schichtverbundes ist, welcher mindestens folgende Schichten in folgender Reihenfolge umfasst: Glasscheibe (201), fünfte elektrisch leitfähige Schicht (210), Ionen speichernde Schicht (211), Ionen leitende Schicht (212), unterstöchiometrische Wolframoxid-Schicht (213), sechste elektrisch leitfähige Schicht (214), Glasscheibe (215); wobei zwischen der fünften und sechsten transparenten leitfähigen Schicht (210; 214) eine vierte elektrische Spannung schaltbar ist.

20. Wandelement nach Anspruch 18, **dadurch gekennzeichnet, dass** das vierte Schichtsystem eine Ytrium-Schicht und eine Paladium-Schicht umfasst; wobei in den Hohlraum Wasserstoff einlassbar ist.

21. Wandelement nach einem der vorhergehenden Ansprüche, **dadurch gekennzeichnet, dass** zumindest eines der Schichtsysteme: erstes Schichtsystem, zweites Schichtsystem, drittes Schichtsystem oder viertes Schichtsystem auf einem flexiblen Trägersubstrat abgeschieden und das flexible Trägersubstrat mit dem darauf abgeschiedenen Schichtsystem auf das erste oder zweite transparente Substrat laminiert ist.

## Claims

1. Light-generating wall element (100; 200) comprising a first transparent substrate (101; 201) and a second transparent substrate (102; 202), the transparent substrates of plate-shaped design being arranged opposite one another and bounding a cavity (104; 204), **characterized in that** deposited on the second substrate (102; 202), at least in a surface region, is at least a first layer system, comprising a first electrically conductive layer (106; 206), followed by a light-emitting layer (105; 205) and a second electrically conductive layer (107; 207), and it being possible to switch a first electric voltage between the first electrically conductive layer (106; 206) and the second electrically conductive layer (107; 207).

2. Wall element according to Claim 1, **characterized in that** the wall element (100; 200) is designed as window, as door or as room divider.

3. Wall element according to Claim 1 or 2, **characterized in that** the first transparent substrate (101; 201) and/or the second transparent substrate (102; 202) consists of glass or of a plastic, and **in that** the first layer system is of transparent design.

4. Wall element according to one of the preceding claims, **characterized in that** the first electrically conductive layer (106; 206) and/or the second electrically conductive layer (107; 207) is/are designed as a 50 nm to 500 nm thick individual layer, the individual layer consisting of a transparent conductive oxide and, in particular, of indium tin oxide or of aluminium-doped zinc oxide.

5. Wall element according to one of the preceding claims, **characterized in that** the first electrically conductive layer or/and the second electrically conductive layer consists/consist of a layer composite, the layer composite comprising at least a 20 nm to 50 nm thick first layer and a 20 nm to 50 nm thick second layer each made from a transparent conductive oxide, in particular from indium tin oxide or from aluminium-doped zinc oxide, between which a 5 nm to 15 nm thick silver layer is embedded.

6. Wall element according to one of Claims 1 to 5, **characterized in that** the light emitting layer consists of an inorganic semiconductor material and has a layer thickness of from 10 nm to 1000 nm.

7. Wall element according to Claim 6, **characterized in that** the light emitting layer consists of at least one of the following compounds: gallium aluminium arsenide, gallium arsenide phosphide, aluminium indium gallium phosphide, gallium phosphide, indium gallium nitride or gallium nitride.

8. Wall element according to one of Claims 1 to 5, **characterized in that** the light emitting layer (105; 205) consists of an organic semiconductor material and has a layer thickness of from 10 nm to 1000 nm.

9. Wall element according to Claim 8, **characterized in that** the light emitting layer (105; 205) consists of at least one of the following compounds: quinacridone, flavanthrone or perinone.

10. Wall element according to one of the preceding claims, **characterized in that** the first layer system is deposited on that side of the second transparent substrate (102; 202) which faces the cavity, or on that side averted from the cavity.

11. Wall element according to one of Claims 1 to 10, **characterized in that** the first layer system is simultaneously designed as low-e layer system, or **in that** deposited on the first transparent substrate is a second layer system which has low-e properties, the second layer system, beginning at the substrate, comprising at least the following layers: metal oxide layer, silver layer, metal layer, metal oxide layer.

12. Wall element according to one of the preceding claims, **characterized in that** the wall element has an emissivity of at most 0.1 perpendicular to the surface.

13. Wall element according to one of Claims 1 to 10, **characterized in that** the wall element has a transparency of at least 35% in the visible region.

14. Wall element according to one of the preceding claims, **characterized in that** the cavity (104; 204) is filled with a gas, in particular with argon, krypton or xenon or a mixture of these gases.

15. Wall element according to one of Claims 1 to 14, **characterized in that** when light is incident on the wall element a second electric voltage can be tapped between the first electrically conductive layer and the second electrically conductive layer.

16. Wall element according to one of Claims 1 to 14, **characterized in that** the first transparent substrate comprises a third layer system by means of which a third electric voltage can be generated when light is incident on the wall element.

17. Wall element according to Claim 16, **characterized in that** the third layer system comprises at least the following steps, beginning at the substrate: third electrically conductive layer, layer made from quinacridone, and fourth electrically conductive layer, it being possible to tap the third electric voltage between the third electrically conductive layer and the fourth electrically conductive layer.

18. Wall element according to one of the preceding claims, **characterized in that** the first transparent substrate comprises a fourth layer system which is designed as switchable mirror, or/and can be varied by means of the transparency of the wall element.

19. Wall element according to Claim 18, **characterized in that** the first transparent substrate (201) is a component of a layer composite which comprises at least the following layers in the following sequence: glass plate (201), fifth electrically conductive layer (210), ion-storing layer (211), ion-conducting layer (212), substoichiometric tungsten oxide layer (213), sixth electrically conductive layer (214), and glass plate (215); it being possible for a fourth electric voltage to be switched between the fifth and sixth transparent conductive layers (210; 214).

20. Wall element according to Claim 18, **characterized in that** the fourth layer system comprises an yttrium layer and a palladium layer; it being possible to admit hydrogen into the cavity.

21. Wall element according to one of the preceding claims, **characterized in that** at least one of the layer systems, specifically first layer system, second layer system, third layer system or fourth layer system is deposited on a flexible carrier substrate, and the flexible carrier substrate with the layer system deposited thereon is laminated onto the first or second transparent substrate.

## Revendications

1. Elément mural lumineux (100, 200) comprenant un premier substrat transparent (101, 201) et un second substrat transparent (102, 202),
les deux substrats transparents réalisés en forme de plaques étant situés l'un en regard de l'autre pour délimiter un volume (104, 204),
**caractérisé en ce qu'**
au moins un premier système de couches comprenant une première couche électroconductrice (106, 206) suivie d'une couche photoémissive (105, 205) et d'une seconde couche électroconductrice (107, 207) est déposé sur le second substrat (102, 202) au moins dans une zone de sa surface, et
une première tension électrique peut être appliquée entre la première couche électroconductrice (106, 206) et la seconde couche électroconductrice (107, 207).

2. Elément mural selon la revendication 1,
**caractérisé en ce qu'**
il (100, 200) est réalisé sous la forme d'une fenêtre, d'une porte ou d'une cloison.

3. Elément mural selon la revendication 1 ou 2,
**caractérisé en ce que**
le premier substrat transparent (101, 201) et/ou le second substrat transparent (102, 202) sont en verre ou en une matière plastique, et
le premier système de couches est transparent.

4. Elément mural selon l'une des revendications précédentes,
**caractérisé en ce que**
la première couche électroconductrice (106, 206) et/ou la seconde couche électroconductrice (107, 207) sont constituées par une couche individuelle d'une épaisseur comprise entre 50 nm et 500 nm,
cette couche individuelle étant en un oxyde conducteur, transparent, et notamment en oxyde d'indium-étain ou en oxyde de zinc dopé avec de l'aluminium.

5. Elément mural selon l'une des revendications précédentes,
**caractérisé en ce que**
la première couche électroconductrice et/ou la seconde couche électroconductrice sont formées d'une combinaison de couches,
cette combinaison de couches comportant au moins une première couche d'une épaisseur comprise entre 20 nm et 50 nm et une seconde couche d'une épaisseur comprise entre 20 nm et 50 nm, chacune de ces couches étant en un oxyde conducteur transparent, notamment en oxyde d'indium-étain ou en oxyde de zinc dopé avec de l'aluminium, entre lesquelles est intégrée une couche d'argent d'une épaisseur comprise entre 5 nm et 15 nm.

6. Elément mural selon l'une des revendications 1 à 5,
**caractérisé en ce que**
la couche photoémettrice est réalisée en un matériau semi-conducteur anorganique et son épaisseur de couche est comprise entre 10 nm et 1000 nm.

7. Elément mural selon la revendication 6,
**caractérisé en ce que**
la couche photoémettrice est constituée d'au moins un des composés suivants : arséniure de gallium-aluminium, phosphure arséniure de gallium, phosphure d'aluminium-indium-gallium, phosphure de gallium, nitrure d'indium-gallium ou nitrure de gallium.

8. Elément mural selon l'une des revendications 1 à 5,
**caractérisé en ce que**
la couche photoémettrice (105, 205) est en un matériau semi-conducteur organique et a une épaisseur de couche comprise entre 10 nm et 1000 nm.

9. Elément mural selon la revendication 8,
**caractérisé en ce que**
la couche photoémettrice (105, 205) est constituée d'au moins l'un des composés suivants quinacridone, flavanthrone ou perinone.

10. Elément mural selon l'une des revendications précédentes,
**caractérisé en ce que**
le premier système de couches est déposé sur le côté tourné vers le volume ou sur le côté non tourné vers le volume du second substrat transparent (102, 202).

11. Elément mural selon l'une des revendications 1 à 10,
**caractérisé en ce que**
le premier système de couches est en même temps réalisé sous la forme d'un système de couches à faible émissivité (Low. E) ou un second système de couches est déposé sur le premier substrat transparent, ce second système ayant des propriétés de faible émissivité,
le second système de couches comprenant à partir du substrat, au moins les couches suivantes :
couche d'oxyde métallique, couche d'argent, couche de métal, couche d'oxyde métallique.

12. Elément mural selon l'une des revendications précédentes,
**caractérisé en ce que**
l'élément mural a une capacité d'émission maximale de 0,1 dans la direction perpendiculaire à sa surface.

13. Elément mural selon l'une des revendications 1 à 10,
**caractérisé en ce que**
l'élément mural a une transparence d'au moins 35 % dans le domaine de la lumière visible.

14. Elément mural selon l'une des revendications précédentes,
**caractérisé en ce que**
le volume (104, 204) est rempli d'un gaz, notamment d'argon, de crypton ou de xénon ou d'un mélange de ces gaz.

15. Elément mural selon l'une des revendications 1 à 14,
**caractérisé en ce qu'**
en cas de lumière incidente tombant sur l'élément mural, une seconde tension électrique peut être prélevée entre la première couche électroconductrice et la seconde couche électroconductrice.

16. Elément mural selon l'une des revendications 1 à 14,
**caractérisé en ce que**
le premier substrat transparent comporte un troisième système de couches qui génère une troisième tension électrique en cas de lumière incidente tombant sur l'élément mural.

17. Elément mural selon la revendication 16,
**caractérisé en ce que**
le troisième système de couches comprend au moins les couches suivante à partir du substrat : troisième couche électroconductrice, couche de quinacridone, quatrième couche électroconductrice,
la troisième tension électrique pouvant être prélevée entre la troisième couche électroconductrice et la quatrième couche électroconductrice.

18. Elément mural selon l'une des revendications précédentes,
**caractérisé en ce que**
le premier substrat transparent comprend un quatrième système de couches réalisé comme miroir commutable et/ou par lequel on peut modifier la transparence de l'élément mural.

19. Elément mural selon la revendication 18,
**caractérisé en ce que**
le premier substrat transparent (201) fait partie d'une combinaison de couches comprenant au moins les couches suivantes dans l'ordre suivant : vitre (201), cinquième couche électroconductrice (210), couche formant barrière aux ions (211), couche conductrice d'ions (212), couche d'oxyde de tungstène sous stoechiométrique (213), sixième couche électroconductrice (214), vitre (215),
une quatrième tension électrique étant applicable entre la cinquième et la sixième couche conductrice transparente (210, 214).

20. Elément mural selon la revendication 18,
**caractérisé en ce que**
le quatrième système de couches comprend une couche d'yttrium et une couche de palladium,
de l'hydrogène pouvant être introduit dans le volume.

21. Elément mural selon l'une des revendications précédentes,
**caractérisé en ce qu'**
au moins l'un des systèmes de couches suivants : premier système de couches, second système de couches, troisième système de couches, ou quatrième système de couches, est déposé sur un substrat de support souple, et ce substrat de support souple est laminé avec le système de couches déposé sur celui-ci, sur le premier ou le second substrat transparent.
